# EUROPEAN PATENT SPECIFICATION

(11) **EP 0 830 735 B1**
(45) Date of publication and mention of the grant of the patent: **08.11.2000**
(21) Application number: 96918445.6
(22) Date of filing: 07.06.1996
(51) Int. Cl.: H03K 19/177

(54) **FIELD PROGRAMMABLE GATE ARRAY (FPGA) WITH INTERCONNECT ENCODING**
ANWENDERPROGRAMMIERBARES GATTERFELD (FPGA) MIT KODIERTER VERBINDUNDSSTRUKTUR
RESEAU DE PORTES PROGRAMMABLE PAR L'UTILISATEUR (FPGA) A CODAGE D'INTERCONNEXION

(30) Priority: 09.06.1995 US 108
(43) Date of publication of application: 25.03.1998
(73) Proprietor: ADVANCED MICRO DEVICES INC., Sunnyvale, California 94088-3453 (US)
(72) Inventor: SHARPE-GEISLER, Bradley, A., San Jose, CA 95120 (US)
(74) Representative: Picker, Madeline Margaret
(86) International application number: US9609992
(87) International publication number: WO9642140

(56) References cited:
- US-A- 4 721 868
- US-A- 4 758 746
- US-A- 5 381 058
- US-E- R E34 363

## Description

### BACKGROUND OF THE INVENTION

### 1. Field of the Invention

The present invention relates to a method of programming a field programmable gate array (FPGA). More particularly, the present invention relates to controlling programming of programmable interconnect points (PIPs) in an FPGA to connect the outputs of configurable logic blocks (CLBs) to interconnect lines.

### 2. Description of the Related Art

US-A-5 381 058 discloses a prior art FPGA.

US-E-RE34 363 discloses a prior art configurable logic array having configurable interconnect.

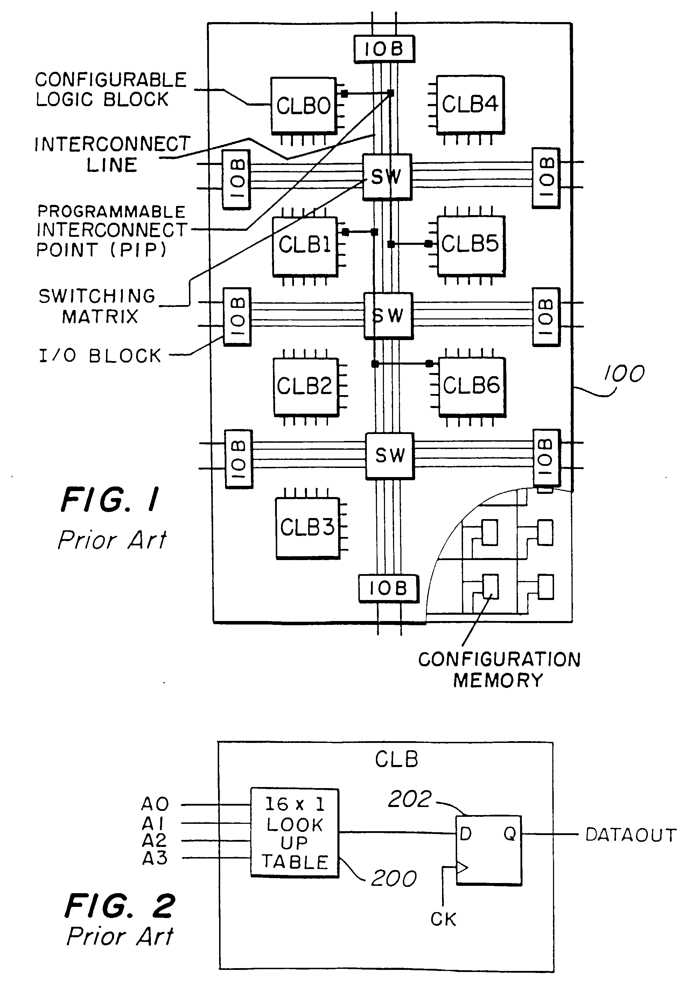

Fig. 1 shows components of a typical FPGA 100. The typical FPGA includes input/output blocks (IOBs), an array of configurable logic blocks (CLBs), resources for interconnection of the CLBs, and a configuration memory. The IOBs are arranged around the perimeter of the device and provide an interface between internal components of the FPGA and external package pins. The CLBs are programmed to implement Boolean functions. The interconnect resources connect the CLBs and IOBs and include interconnect lines, programmable interconnect points (PIPs) and switching matrixes (SWs). The PIPs and switching matrixes connect the interconnect lines to form specific paths between CLBs, or between a CLB and an IOB. PIPs, as well as switching matrixes, are programmed to make connections by memory cells in the configuration memory.

Fig. 2 shows components of a typical CLB used in an FPGA. Each CLB utilizes a subset of memory elements in the configuration memory as a 16 X 1 bit look up table 200. Input lines of a CLB, A₀-A3, are decoded in the look up table 200 to select a memory cell in the look up table 200 to connect to a register 202. The register 202 provides the CLB output. By appropriately programming the look up table 200, the CLB will function as logic to implement Boolean functions.

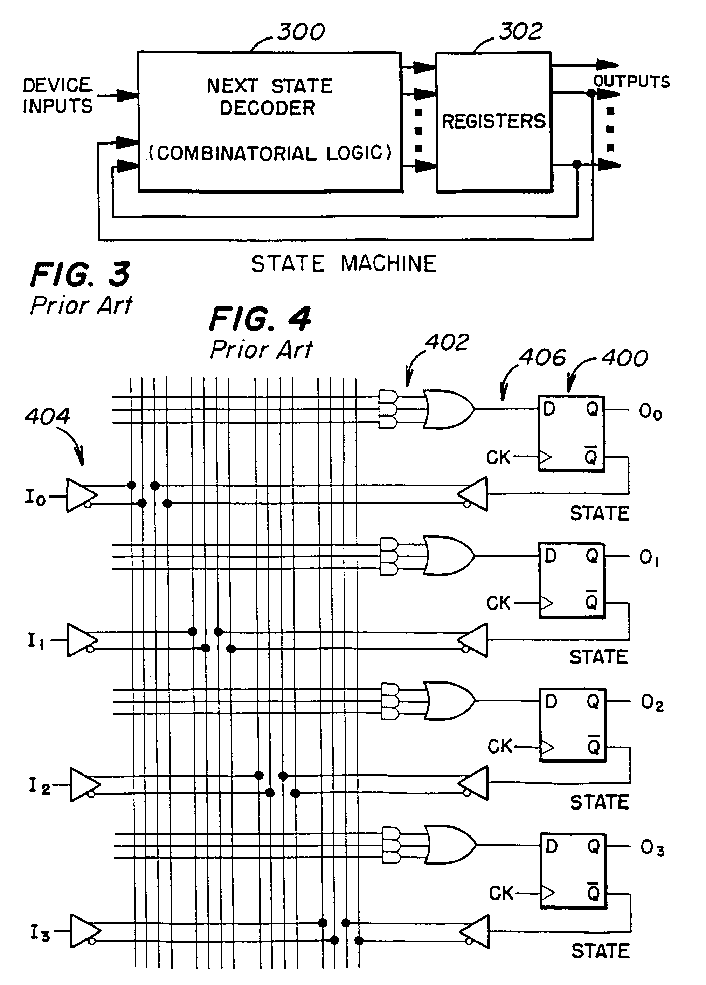

An FPGA can be configured to form a state machine, a typical state machine being shown in block diagram in Fig. 3. In utilizing an FPGA to form a state machine, the 16 X 1 bit look up tables of the CLBs are configured to provide the combinatorial logic to form the next state decoder 300. The next state decoder 300 provides outputs to registers 302 which are also provided by the CLBs. To complete a state machine, outputs of the registers 302 are fed back to inputs of the next state decoder 300, and are also provided as outputs of the state machine using interconnect resources of an FPGA.

In making state machines utilizing an FPGA, the one hot approach is typically utilized. With the one hot approach, only one CLB output is high at a time. For instance, for the FPGA of Fig. 1 having 8 CLBs, to implement an 8 state state machine, the possible CLB register outputs for each of the 8 states are shown in Table A, with a 1 representing a high CLB output and a 0 representing a low CLB output.

**TABLE A**

| | 1 | 2 | 3 | 4 | 5 | 6 | 7 | 8 |
|---|---|---|---|---|---|---|---|---|
| CLB0 | 1 | 0 | 0 | 0 | 0 | 0 | 0 | 0 |
| CLB1 | 0 | 1 | 0 | 0 | 0 | 0 | 0 | 0 |
| CLB2 | 0 | 0 | 1 | 0 | 0 | 0 | 0 | 0 |
| CLB3 | 0 | 0 | 0 | 1 | 0 | 0 | 0 | 0 |
| CLB4 | 0 | 0 | 0 | 0 | 1 | 0 | 0 | 0 |
| CLB5 | 0 | 0 | 0 | 0 | 0 | 1 | 0 | 0 |
| CLB6 | 0 | 0 | 0 | 0 | 0 | 0 | 1 | 0 |
| CLB7 | 0 | 0 | 0 | 0 | 0 | 0 | 0 | 1 |

Fig. 4 shows circuitry for a typical programmable array logic (PAL) device. As will be described, a typical PAL device includes a limited number of registers 400, but a wide decoding capability in comparison to a FPGA. As shown with the PAL of Fig. 4, decoding is provided utilizing combinatorial logic including AND and OR gates 402 connected to inputs of registers 400. Decoding of up to 16 inputs, 8 provided through input buffers 404 from inputs I₀-I₃ and 8 provided through buffers 406 as fed back from registers 400, is provided through the logic 402 to the input of each of the registers 400. Although Fig. 4 shows decoding of up to 16 inputs to provide a result to a single register, much wider decoding is typical in a PAL. In the FPGA of Fig. 1 with a CLB configured as shown in Fig. 2, which is typical, decoding of only 4 inputs, such as A₀-A₃ is provided by logic connected to a register, such as 202, but a total of 8 registers are available in the FPGA.

To implement a state machine using a PAL device, the wide decoding capability of the PAL is utilized to decode the next state as well as to encode the outputs. By utilizing next state decoding, as well as output encoding, an 8 state state machine can be implemented with 3 of the register outputs shown in Fig. 4. For example, with the PAL of Fig. 4, the eight possible states of flip flop outputs O₀-O₂ are shown in Table B.

**TABLE B**

| | 1 | 2 | 3 | 4 | 5 | 6 | 7 | 8 |
|---|---|---|---|---|---|---|---|---|
| O₀ | 0 | 1 | 0 | 1 | 0 | 1 | 0 | 1 |
| O₁ | 0 | 0 | 1 | 1 | 0 | 0 | 1 | 1 |
| O₂ | 0 | 0 | 0 | 0 | 1 | 1 | 1 | 1 |

For an FPGA, because of the limited inputs to a CLB limiting the decoding ability, output encoding is not typically performed.

To implement the one hot approach typically utilized in FPGAs in a PAL device, the additional encoding capability of the PAL would be wasted. Additionally, because of the limited number of registers, to implement the one hot approach, multiple PAL devices may be necessary. For the FPGA, a significant number of registers are available, making the one hot approach more feasible.

However, when using the one hot approach, only one CLB output is connected to an interconnect line in one routing path at a time so that separate routing paths are used for each CLB output. Fig. 1 highlights interconnect lines forming separate routing paths from CLB0 to CLB5 and from CLB1 to CLB6.

FPGAs operate faster utilizing the one hot approach because gate delays for output encoding are not required. However, limitations to enable implementation of the one hot approach may prevent the FPGA resources from being efficiently utilized to the extent that the advantages of the one hot approach are outweighed.

### SUMMARY OF THE INVENTION

The present invention modifies the method of programming an FPGA to enable a user to have the option to more efficiently use FPGA interconnect resources.

The present invention is a method of programming an FPGA to enable encoding of the CLB outputs. The method of the present invention utilizes the one hot approach in forming a state machine, but modifies the typical interconnect structure of an FPGA. With the present invention, programmable interconnect points (PIPs) may be programmed to connect CLB outputs to interconnect lines so that the interconnect lines indicate states of the CLB outputs in an encoded form.

To provide such encoding, the present invention utilizes less interconnect lines than CLB outputs which are being provided in a non-encoded form. Thus, in the present invention PIPs can connect a single interconnect line to more than one CLB output. Further, PIPs can connect a single CLB output to interconnect lines provided in separate parallel routing paths.

With encoding so provided, more efficient use of the interconnect resources is enabled because the number of interconnect lines required is reduced. Also, because the number of interconnect lines is reduced, the number of SRAM cells required to connect the interconnect lines is reduced.

With the one hot approach utilized and the CLB outputs now possibly being interconnected, to prevent the hot CLB output from adversely affecting the CLB outputs which are not hot, the CLB outputs which are not hot are tri-stated.

To decode the encoded output of interconnect lines to which CLBs are connected, the present invention in one embodiment adds a decoder to typical FPGA circuitry. Alternatively, with a limited number of interconnect lines providing an encoded output, the present invention utilizes a CLB to provide decoding.

### BRIEF DESCRIPTION OF THE DRAWINGS

Further details of the present invention are explained with the help of the attached drawings in which:
Fig. 1 shows a block diagram illustrating components of a typical FPGA;
Fig. 2 shows components of a typical configurable logic block (CLB) used in an FPGA;
Fig. 3 shows a block diagram of a simple state machine;
Fig. 4 shows circuitry for a typical PAL device;
Fig. 5 illustrates the configuration of interconnect resources of an FPGA utilizing the present invention;
Fig. 6 shows circuitry for implementation of the possible interconnections illustrated in Fig. 5;
Fig. 7 shows alternative circuitry to Fig. 6 for implementation of the interconnections of Fig. 5; and
Fig. 8 illustrates decoding of encoded interconnect line outputs utilizing a CLB.

### DETAILED DESCRIPTION

The present invention is a method of programming an FPGA to enable encoding of the CLB outputs. The programming method of the present invention allows PIPs to connect CLB outputs to interconnect lines to provide output encoding.

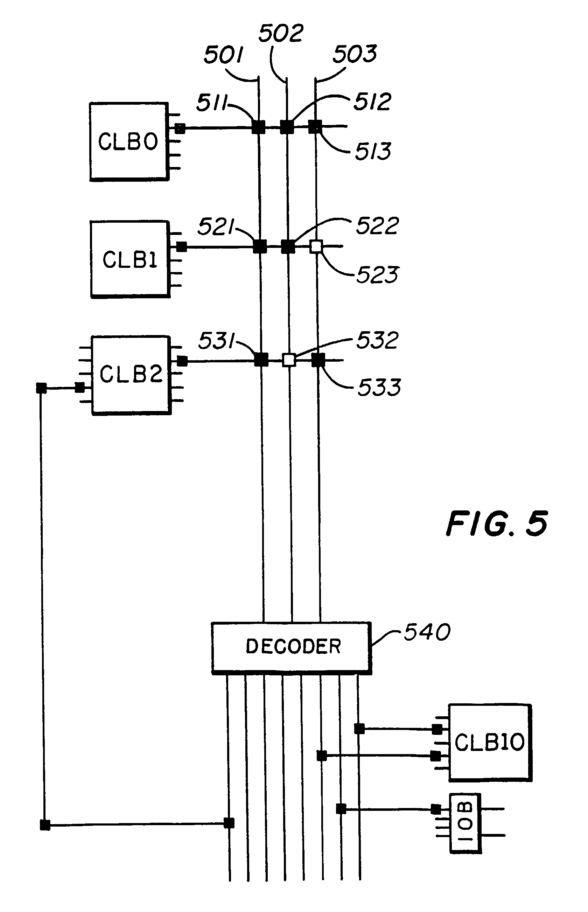

Fig. 5 illustrates how interconnect resources are configured utilizing the method of the present invention. In Fig. 5 CLBs of a FPGA, CLB0-CLB2, are shown each having an output connectable to interconnect lines 501, 502 and 503. Programmable interconnect points (PIPs) 511-513, 521-523, and 531-533 enable connecting the CLBs, CLB0-CLB2, to interconnect lines 501-503 to provide the encoding of the present invention.

In the present invention, PIPs 511-513, 521-523 and 531-533 are controlled to enable connecting a single one of interconnect lines 501-503 to more than one of the CLB0-CLB2 outputs. Further, a single one of the CLB0-CLB2 outputs can be connected to interconnect lines 501-503 which are provided in separate parallel routing paths.

With encoding provided as described by the present invention M CLB outputs of an M state state machine can now be represented using only LOG₂M interconnect lines, where M is an integer. For example, encoding of eight CLB outputs can be provided using three interconnect lines 501-503, as shown in Fig. 5. To illustrate, Table C below shows PIP connections of eight CLB outputs, CLB0-CLB7, to three interconnect lines, IL0-IL2. In Table C a 1 indicates a PIP connection so that a high is on the line when the CLB is high, and a 0 indicates a PIP disconnection so that a low is on the line when the CLB is high.

**TABLE C**

| | IL0 | IL1 | IL2 |
|---|---|---|---|
| CLB0 | 1 | 1 | 1 |
| CLB1 | 1 | 1 | 0 |
| CLB2 | 1 | 0 | 1 |
| CLB3 | 1 | 0 | 0 |
| CLB4 | 0 | 1 | 1 |
| CLB5 | 0 | 1 | 0 |
| CLB6 | 0 | 0 | 1 |
| CLB7 | 0 | 0 | 0 |

Fig. 5 shows programming similar to Table C. In Fig. 5, PIPs shown as darkened, such as 511 and 521, indicate the PIPs are programmed to create a 1 as defined for Table C, while PIPs not darkened, such as 523 and 532, indicate the PIPs are programmed to create a 0 as defined for Table C. Although shown connected in a particular manner, CLB outputs may alternatively be programmed to be connected or disconnected by any of PIPs 511-513, 521-523 and 531-533 to provide encoding.

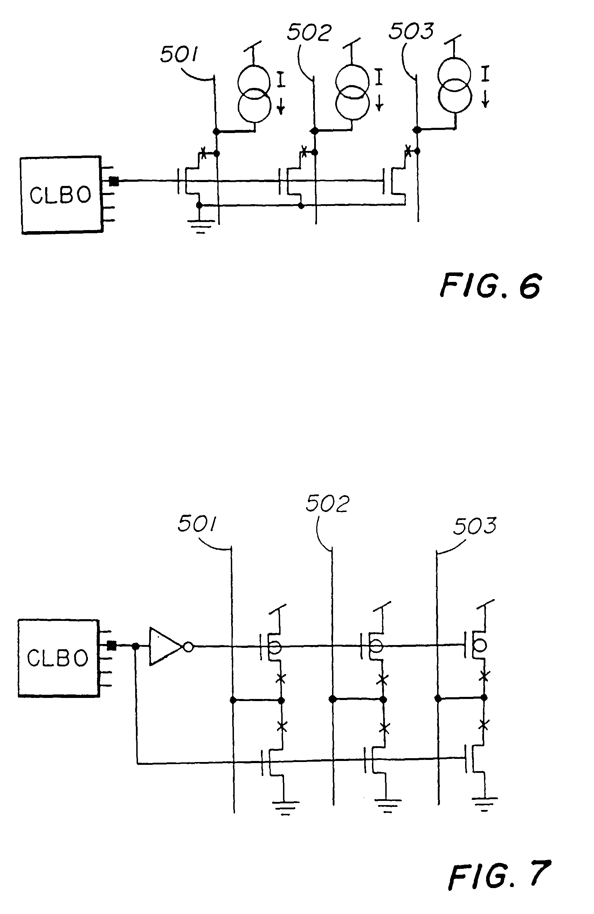

Fig. 6 shows circuitry for implementation of the possible interconnections illustrated in Fig. 5. As shown, a CLB output drives the gates of NMOS transistors having sources connected to Vss. Drains of the NMOS transistors driven by the CLB are then connected or disconnected to respective lines 501-503 using PIPs which are illustrated by an X in Fig. 5. Lines 501-503 are further driven by current sources.

Fig. 7 shows alternative circuitry to Fig. 6 for implementation of the interconnections of Fig. 5. In Fig. 7, a CLB output is provided directly to gates of NMOS transistors having sources connected to Vss. Further, the CLB output is provided through an inverter to gates of PMOS transistors having sources connected to
Vdd. Drains of the PMOS transistors are then selectively connected or disconnected to respective lines 501-503 using PIPs illustrated by an X. Further, Drains of the NMOS transistors are selectively connected or disconnected to respective lines 501-503 using PIPs as shown.

Because the circuitry of Fig. 7 utilizes CMOS logic, it is faster and utilizes less power than the circuitry of Fig. 6. Further in Fig. 7 when PIPs are disconnected, the CLB output will be tri-stated, while in Fig. 6 when PIPs are disconnected, the CLB output will be open drain.

With encoding provided as described, only one CLB output which is encoded can be high at a time. For instance, referring to Table C, with CLB5 and CLB6 high, the interconnect lines would erroneously indicate that CLB4 is high. Thus, the method of the present invention utilizes the one hot approach to form a state machine.

Also with encoding provided as described above, CLB outputs may be interconnected. Even with the one hot approach, with CLB outputs interconnected a CLB output which is hot may cause CLB outputs which are not hot to change states. Therefore, in the present invention outputs of CLBs which are not hot are preferably either tri-stated or open drain.

By providing output encoding in programming an FPGA to form a state machine, more efficient use of the interconnect resources is enabled, particularly with long routing paths, because the necessary number of interconnect lines is reduced. What would otherwise require M routing paths for an M state state machine now requires only LOG₂M routing paths.

Further, with the number of interconnect lines reduced, the number of SRAM cells required for programming the interconnect lines is reduced. A FPGA may typically include 270 SRAM configuration memory cells per CLB. With 32 memory cells utilized in the CLB look up table, the remaining SRAM cells, 270-32=238, will typically be utilized for PIPs. Efficient use of the 238 SRAM cells per CLB can, thus, significantly reduce FPGA resources and, thus, the total size of an FPGA required for a particular application.

To decode the encoded lines 501-503 as provided by the present invention, one of two methods may be utilized. In a first method, a separate decoder 540 may be provided to decode the three encoded lines 501-503, as shown in Fig. 5. The output of decoder 540 can then provide eight paths. The paths from decoder 540 can then be fed back to the inputs of the CLBs, such as shown to CLB2, provided to the address inputs of additional CLBs, such as shown to CLB10, or provided to an IOB, as shown.

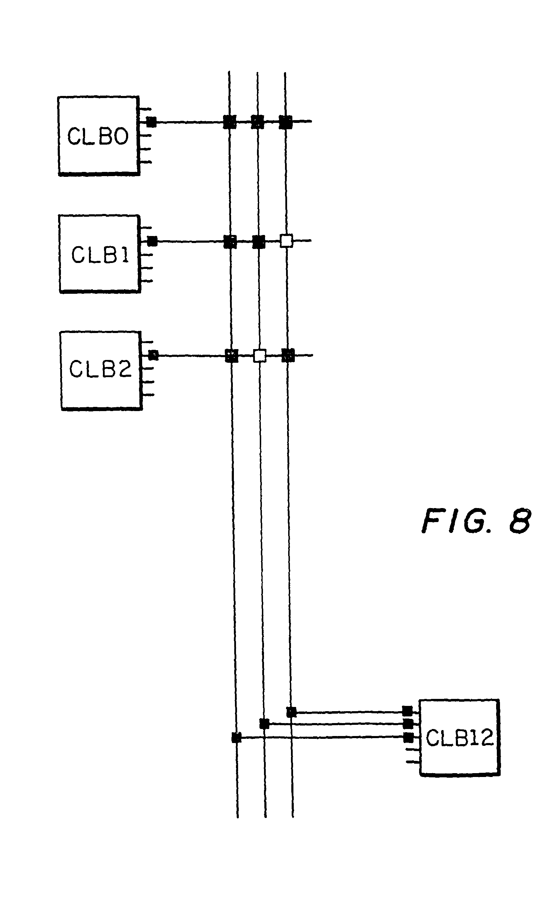

Alternatively, with a limited number of encoded lines, decoding can be provided in a CLB, such as CLB12 as shown in Fig. 8. Decoding may, however, be provided more efficiently utilizing a separate decoder, as in Fig. 5, rather than utilizing a CLB resource, as in Fig. 8, because utilization of only the decoder in the CLB may waste the remaining CLB resources.

Although the invention has been described above with particularity, this was merely to teach one of ordinary skill in the art how to make and use the invention. Many modifications will fall within the scope of the invention, as that scope is defined by the claims which follow.

## Claims

1. A method of programming a field programmable gate array (FPGA) comprising configurable logic blocks (CLBs) having outputs, programmable interconnect points (511-513, 521-523. 531-533) and interconnect lines (501,502,503) and wherein the number of interconnect lines (501. 502, 503) is less than the number of CLB outputs, said method characterised in that it comprises the steps of:
programming the CLBs to that only one of the CLB outputs can be high at a time; and
programming the programmable interconnect points (511-513, 521-523, 531-533) so that the interconnect lines (501, 502, 503) in an encoded manner indicate which CLB output, if any, is high.

2. A method as claimed in Claim 1, wherein when an output of one of the CLBs is high, outputs of remaining ones of the CLBs are tri-stated.

3. A method as claimed in Claim 1, wherein the interconnect lines are connected to the inputs of a decoder (540).

4. A method as claimed in Claim 1, further comprising the steps of:
programming programmable interconnect points to further connect the interconnect lines to inputs of an additional CLB; and
programming the additional CLB to function as a decoder.

5. A method as claimed in Claim 1, wherein:
programmable interconnect points are programmed to connect more than one of the CLB outputs to a single interconnect line.

6. A method as claimed in Claim 1, wherein:
programmable interconnect points are programmed to connect one of the CLB outputs to interconnect lines provided in separate parallel routing paths.

7. A field programmable gate array (FPGA) comprising:
configurable logic blocks (CLBs) having outputs:
interconnect lines (501,502,503); and
programmable interconnect points (511-513, 521-523, 531-533) which can be programmed to connect the outputs of the CLBs to the interconnect lines;
said FPGA characterised in that
the interconnect lines (501, 502, 503) are fewer in number than the CLB outputs; and in that
said FPGA is adapted for programming the programmable interconnect points (511-513, 521-523, 531-533) so that the interconnect lines (501,502,503) in an encoded manner indicate which CLB output, if any is high, when the FPGA is programmed so that only one of the CLB outputs can be high at a time.

8. An FPGA as claimed in Claim 7, wherein the CLBs can be programmed so that only one of the CLB outputs is high at a time.

9. An FPGA as claimed in Claim 7, further comprising:
a decoder (540) having inputs connected to the interconnect lines (501,502,503).

10. An FPGA as claimed in Claim 7, further comprising:
an additional CLB having inputs connectable to the interconnect lines, (501, 502,503) the additional CLB being programmable to function as a decoder.

11. An FPGA as claimed in Claim 7, wherein
the programmable interconnect points can be programmed to connect more than one of the CLB outputs to one of the interconnect lines.

12. An FPGA as claimed in Claim 7, wherein
the programmable interconnect points can be programmed to connect one of the CLB outputs to more than one of the interconnect lines provided in separate parallel routing paths.

## Patentansprüche

1. Verfahren zum Programmieren eines feldprogrammierbaren Gatterarrays (FPGA) mit konfigurierbaren Logikblöcken (CLB) mit Ausgängen, programmierbaren Zwischenverbindungspunkten (511-513, 521-523, 531-533) und Zwischenverbindungsleitungen (501,502,503), wobei die Zahl der Zwischenverbindungsleitungen (501, 502, 503) kleiner als die Zahl der CLB Ausgänge ist, wobei das Verfahren durch die folgenden Schritte gekennzeichnet ist:
Programmieren der CLB derart, daß jeweils nur einer der CLB Ausgänge einen High-Pegel aufweisen kann; und
Programmieren der programmierbaren Zwischenverbindungspunkte (511-513, 521-523,531-533) derart, daß die Zwischenverbindungsleitungen (501, 502, 503)codiert angeben, welcher CLB Ausgang, falls überhaupt, einen High-Pegel aufweist.

2. Verfahren nach Anspruch 1, bei dem, wenn ein Ausgang eines der CLB high ist, die Ausgänge der übrigen CLB einen Dreizustand aufweisen.

3. Verfahren nach Anspruch 1, bei dem die Zwischenverbindungsleitungen mit den Eingängen eines Decodierers (540) verbunden sind.

4. Verfahren nach Anspruch 1, ferner mit den Schritten
des Programmierens programmierbarer Zwischenverbindungspunkte, um die Zwischenverbindungsleitungen weiter mit Eingängen eines zusätzlichen CLB zu verbinden; und
des Programmierens des zusätzlichen CLB für eine Funktion als Decodierer.

5. Verfahren nach Anspruch 1, bei dem programmierbare Zwischenverbindungspunkte programmiert werden, um mehr als einen derCLB Ausgänge mit einer einzelnen Zwischenverbindungsleitung zu verbinden.

6. Verfahren nach Anspruch 1, bei dem programmierbare Zwischenverbindungspunkte zum Verbinden eines der CLB Ausgänge mit Zwischenverbindungsleitungen, die in separaten parallelen Leitungspfaden vorgesehen sind, programmiert werden.

7. Feldprogrammierbares Gatterarray (FPGA) mit
konfigurierbaren Logikblöcken (CLB) mit Ausgängen,
Zwischenverbindungsleitungen (501, 502, 503), und
programmierbaren Zwischenverbindungspunkten (511-513, 521-523, 531-533), die zum Verbinden der Ausgänge der CLB mit den Zwischenverbindungsleitungen programmierbar sind,
wobei die FPGA dadurch gekennzeichnet ist, daß
die Zahl der Zwischenverbindungsleitungen (501, 502, 503) kleiner als die Zahl der CLB Ausgänge ist, und
die FPGA geeignet ist, die programmierbaren Zwischenverbindungspunkte (511-513, 521-523, 531-533) derart zu programmieren, daß die Zwischenverbindungsleitungen (501, 502, 503)codiert angeben, welcher CLB Ausgang, falls überhaupt, einen High-Pegel aufweist, wenn die FPGA derart programmiert ist, daß jeweisl nur einerder CLB Ausgänge einen High-Pegel aufweisen kann.

8. FPGA nach Anspruch 7, bei der die CLB derart programmierbar sind, daß jeweils nur einer der CLB Ausgänge high ist.

9. FPGA nach Anspruch 7, ferner mit einem Decodierer (540), dessen Eingänge mit den Zwischenverbindungsleitungen (501, 502, 503) verbunden sind.

10. FPGA nach Anspruch 7, ferner mit einem zusätzlichen CLB mit Eingängen, die mit den Zwischenverbindungsleitungen (501, 502, 503) verbindbar sind, wobei der zusätzliche CLB für eine Funktion als Decodierer programmierbar ist.

11. FPGA nach Anspruch 7, bei dem die programmierbaren Zwischenverbindungspunkte programmiert werden können, um mehr als einen der CLB Ausgänge mit einer der Zwischenverbindungsleitungen zu verbinden.

12. FPGA nach Anspruch 7, bei dem die programmierbaren Zwischenverbindungspunkte zum Verbinden eines der CLB Ausgänge mit mehr als einer Zwischenverbindungsleitung, die in separaten parallelen Leitungspfaden vorgesehen sind, programmiert sind.

## Revendications

1. Procédé de programmation d'un réseau de portes programmable par l'utilisateur (FPGA) comprenant des blocs de logique configurable (CLB)comportant des sorties, des points d'interconnexion programmables (511-513, 521-523, 531-533) et des lignes d'interconnexion (501, 502, 503) et dans lequel le nombre de lignes d'interconnexion (501, 502, 503) est inférieur au nombre de sortie de CLB, ledit procédé étant caractérisé en ce qu'il comprend les étapes consistant à :
programmer les blocs CLB pour que seulement l'une des sorties de CLB puisse être à l'état haut en même temps ; et
programmer les points d'interconnexion programmables (511-513, 521-523, 531-533) de sorte que les lignes d'interconnexion (501, 502, 503) suivant une manière codée indiquent quelle sortie des CLB, s'il y en a, se trouve à l'état haut.

2. Procédé selon la revendication 1, dans lequel, lorsqu'une sortie de l'un des blocs CLB est à l'état haut, les sorties des blocs restants des CLB sont à trois états.

3. Procédé selon la revendication 1, dans lequel les lignes d'interconnexion sont connectées aux entrées d'un décodeur (540).

4. Procédé selon la revendication 1, comprenant, de plus, les étapes consistant à :
programmer des points d'interconnexion programmable afin de connecter, de plus, les lignes d'interconnexion aux entrées d'un bloc CLB supplémentaire; et
programmer le bloc CLB supplémentaire pour qu'il fonctionne comme un décodeur.

5. Procédé selon la revendication 1, dans lequel :
des points d'interconnexion programmables sont programmés pour connecter plus d'une des sorties des CLB à une seule ligne d'interconnexion.

6. Procédé selon la revendication 1, dans lequel :
des points d'interconnexion programmables sont programmés pour connecter l'une des sorties des CLB aux lignes d'interconnexion fournies dans des voies d'acheminement parallèles séparées.

7. Réseau de portes programmable par l'utilisateur (FPGA) comprenant :
des blocs de logique configurables (CLB) comportant des sorties ;
des lignes d'interconnexion (501, 502, 503) ; et
des points d'interconnexion programmables (511-513, 521-523, 531-533) qui peuvent être programmés en vue de connecter les sorties des CLB aux lignes d'interconnexion ;
ledit réseau FPGA étant caractérisé en ce que
les lignes d'interconnexion (501, 502, 503) sont d'un nombre inférieur au nombre de sorties de CLB ; et en ce que
ledit FPGA est adapté pour programmer les points d'interconnexion programmables (511-513, 521-523, 531-533) de sorte que les lignes d'interconnexion (501, 502, 503) suivant une façon codée indiquent quelle sortie de CLB, s'il y en a, est à l'état haut, lorsque le FPGA est programmé de sorte qu'une seule des sorties des CLB peut être programmée en même temps à l'état haut.

8. Réseau FPGA selon la revendication 7, dans lequel les blocs CLB peuvent être programmés de façon que seulement l'une des sorties des CLB se trouve en même temps à l'état haut.

9. Réseau FGPA selon la revendication 7, comprenant, de plus :
un décodeur (540) comportant des entrées connectées aux lignes d'interconnexion (501, 502, 503).

10. Réseau FGPA selon la revendication 7, comprenant, de plus :
un bloc CLB supplémentaire ayant des entrées pouvant être connectées aux lignes d'interconnexion (501, 502, 503), le CLB supplémentaire pouvant être programmé pour fonctionner comme un décodeur.

11. Réseau FPGA selon la revendication 7, dans lequel :
les points d'interconnexion programmables peuvent être programmés pour connecter plus d'une des sorties de CLB à l'une des lignes d'interconnexion.

12. Réseau FPGA selon la revendication 7, dans lequel :
les points d'interconnexion programmables peuvent être programmés pour connecter l'une des sorties des CLB à plusoeurs des lignes d'interconnexion fournies dans des voies d'acheminement parallèles séparées.
